# EUROPEAN PATENT APPLICATION

(11) **EP 2 674 509 A1**
(43) Date of publication of application: **18.12.2013**
(21) Application number: 12744532.8
(22) Date of filing: 25.01.2012
(51) Int. Cl.: C23C 14/02, B32B 15/088, C23C 28/00, C23C 14/14

(54) **TWO-LAYERED COPPER-CLAD LAMINATE MATERIAL, AND METHOD FOR PRODUCING SAME**

(30) Priority: 10.02.2011 JP 2011027100
(71) Applicant: JX Nippon Mining & Metals Corporation, Tokyo 100-8164 (JP)
(72) Inventor: INAZUMI Hajime, Hitachi-city, Ibaraki 317-0056 (JP); SAKAGUCHI Kazuhiko, Hitachi-city, Ibaraki 317-0056 (JP); SASAKI Shinichi, Hitachi-city, Ibaraki 317-0056 (JP)
(74) Representative: Hoarton, Lloyd Douglas Charles
(86) International application number: PCT/JP2012/051550
(87) International publication number: WO 2012/108265

(57) **Abstract**

A two-layered copper-clad laminate material, in which one surface or both surfaces of a polyimide film having a thickness of 12.5 to 50 µm is subjected to a modification treatment by means of a glow discharge plasma treatment in an oxygen gas atmosphere, and a copper layer having a thickness of 1 to 5 µm is formed by means of sputtering or electroplating on one surface or both surfaces of the polyimide film after the modification treatment; characterized in that the integrated intensity ratio of a C1S peak at 287 to 290 eV to a C1S peak at 283 to 287 eV, obtained by analyzing the photoelectron spectroscopy (XPS) spectra of the surface of the polyimide film after the plasma treatment, is within the range of 0.03 to 0.11. The present invention aims at discovering; as a consequence of performing surface characterization by subjecting the PI film surface to XPS analysis before and after the plasma treatment, and of evaluating the dissolution properties and adhesive strength of the PI film before and after the plasma treatment; a two-layered copper-clad laminate material that is ideal to be processed during a wet PI etching step, and a production method for said two-layered copper-clad laminate material.

## Description

### TECHNICAL FIELD

The present invention relates to a two-layered copper-clad laminate material in which a copper layer is formed by sputtering or plating treatment on a polyimide (PI) film, wherein, while maintaining adhesiveness between the metal layer and the PI film, the etching rate of this PI against a PI etching solution remains unchanged compared with an untreated PI film.

### BACKGROUND ART

Lately, flexible circuit boards have been used for various purposes, and the demand characteristics vary depending on the various applications. Two-layered copper-clad laminate (CCL: Cu Clad Laminate) material in which a copper layer is formed by sputtering method or plating method on a polyimide film (PI), a material for flexible circuit boards, is characterized by the ability to form a copper layer of no more than 5 µm thick, as well as by the flexibility in designing the thickness of the film, in comparison to cast materials.

For this reason, this method is suitable as the production method for one-sided or two-sided CCL having a thickness of the copper layer of 2 to 5 µm and the polyimide film thickness of 12.5 to 50 µm, required in applications such as for medical probes and gas electron multipliers.

In the two-layered CCL material manufactured by sputtering or plating method, the copper layer is produced by forming a copper layer having a submicron thickness on a PI film by sputtering method, followed by plating treatment using copper sulfate. The invention for this process in its basic form is disclosed in the Patent Document 1 described below.

The production steps of CCL for such applications include copper layer etching step, press step, PI film etching step and the like. Among these steps, the PI film etching step is especially important since through-holes and flying leads are formed during this step, thereby making flexible circuit design possible.
The PI film etching step can broadly be categorized into two types; the wet process using an etching solution and the dry process using laser or ion irradiation. The wet process has lower production cost compared to the dry process, and is accordingly more suitable for mass production.

In the sputtering method or plating method, PI film is subjected to plasma treatment and the like in order to increase the adhesive strength between the metal layer and the PI. When the PI film is subjected to plasma treatment and the like, reactions such as adsorption, desorption and severing of molecular chains takes place, and the surface of the PI film is thereby modified. When the surface of the PI film is modified, the problem of reduction in the dissolution rate against the PI etching solution can arise, depending on the extent of the modification.

However, reports on the examination of and investigation into the surface modification of PI film, mostly concern only adhesive strength. Thus, these entail a problem of the reduction of dissolution rate against the PI etching solution even after modifying the PI surface to exhibit an excellent adhesive strength, and therefore such a film may be unusable as a material for producing circuits. On the other hand, when the surface modification of the polyimide is not performed, poor adhesive property can lead to the separation of circuits during the etching of the copper layer and the like.

Patent Document 1: US Patent No. 5685970

### SUMMARY OF INVENTION

### [Technical Problem]

In order to solving such the problem, the present invention aims at discovering; as a consequence of performing surface characterization by subjecting the PI film surface to XPS analysis before and after the plasma treatment, and of evaluating the dissolution properties and adhesive strength of the PI film before and after the plasma treatment; a two-layered copper-clad laminate material that is ideal to be processed during a wet PI etching step, and a production method for said two-layered copper-clad laminate material. More specifically, the present invention aims at: providing a two-layered copper-clad laminate material (CCL material) in which a copper layer is formed by means of sputtering or plating on the polyimide film; and especially providing a two-layered copper-clad laminate material (plate), which has a copper layer of a thickness of 5 µm or less and a PI film of a thickness of 12.5 to 50 µm, and exhibits an excellent adhesive properties, and in which dissolution properties of the PI film are not different from that of an untreated PI film, and a production method for the same.

### [Solution to Problem]

In order to make adhesive properties and dissolution properties compatible, an extensive research was conducted, and as the result, a plasma treatment condition for achieving both excellent adhesive properties as well as dissolution properties was discovered in a two-layered copper-clad laminate material in which a copper layer is formed by means of sputtering and plating treatment on a polyimide film.

Based on these findings, the present invention provides the following.
1) A two-layered copper-clad laminate material, in which one surface or both surfaces of a polyimide film having a thickness of 12.5 to 50 µm is subjected to a modification treatment by means of a glow discharge plasma treatment in an oxygen gas atmosphere, and a copper layer having a thickness of 1 to 5 µm is formed by means of sputtering or electroplating on one surface or both surfaces of the polyimide film after the modification treatment; characterized in that the integrated intensity ratio of a C1S peak at 287 to 290 eV to a C1S peak at 283 to 287 eV, obtained by analyzing the surface of the polyimide film after the plasma treatment by means of photoelectron spectroscopy (XPS), is within the range of 0.03 to 0.11. In regard to "C1S" above, it is sometimes referred to as "C1s", however, they are used here interchangeably.

2) The two-layered copper-clad laminate material according to 1) above, characterized in that the polyimide film after the modification treatment does not have a difference in dissolution rate against a polyimide film etching solution compared with an untreated polyimide film.

3) The two-layered copper-clad laminate material according to 1) or 2) above, characterized in that the as-received peel strength, when the thickness of the copper layer is 18 µm, is 0.9 kN/m or more.

4) The two-layered copper-clad laminate material according to any one of 1) to 3) above, characterized in that a tie-coat layer comprising Ni, Cr, Ni-Cu alloy or Ni-Cr alloy is formed on the polyimide film by means of sputtering, prior to forming a copper layer on one surface or both surfaces of the polyimide film.

5) A production method for a two-layered copper-clad laminate material, in which one surface or both surfaces of a polyimide film having a thickness of 12.5 to 50 µm is subjected to a modification treatment by means of a glow discharge plasma treatment in an oxygen gas atmosphere, and a copper layer having a thickness of 1 to 5 µm is formed by means of sputtering or electroplating on one surface or both surfaces of the polyimide film after the modification treatment; characterized in that the integrated intensity ratio of a C1S peak at 287 to 290 eV to a C1S peak at 283 to 287 eV, obtained by analyzing the surface of the polyimide film after the plasma treatment by means of photoelectron spectroscopy (XPS), is within the range of 0.03 to 0.11.

6) The production method for a two-layered copper-clad laminate material according to 5) above, characterized in that a tie-coat layer comprising Ni, Cr, Ni-Cu alloy or Ni-Cr alloy is formed on the polyimide film by means of sputtering, prior to forming a copper layer on one surface or both surfaces of the polyimide film.

7) The two-layered copper-clad laminate material according to 5) or 6) above, characterized in that the modification treatment is performed so that the polyimide film after the modification treatment does not have a difference in dissolution rate against a polyimide film etching solution compared with an untreated polyimide film.

8) The production method for a two-layered copper-clad laminate material according to any one of 5) to 7) above, characterized in that the as-received peel strength, when the thickness of the copper layer is 18 µm, is 0.9 kN/m or more.

### [Effects of Invention]

The two-layered copper-clad laminate material of the present invention has an advantageous effect of having such excellent adhesive properties that the as-received peel strength is 0.9 kN/m or more, and dissolution properties of polyimide film are not different from that of an untreated PI film; in the two-layered copper-clad laminate material (CCL material) in which a copper layer is formed on a polyimide film by means of sputtering and plating treatments, and especially in the two-layered copper-clad laminate material (plate) in which a copper layer having a thickness of no more than 5 µm is formed by means of sputtering or electroplating on one surface or both surfaces of the polyimide film having a thickness of 12.5 to 50 µm.
For this reason, the present invention has the characteristics of being free from the peeling problems encountered during the etching step of copper layer for such applications as medical probes, gas electron multipliers and the like, and of enabling the polyimide film to dissolve easily during the etching step of polyimide film, by subjecting it to modification treatment within the range that would not change the dissolution properties of the polyimide film.

### BRIEF DESCRIPTION OF DRAWINGS

[Figure 1] This is an explanatory diagram showing the process to remove a portion of a polyimide film by an etching solution.
[Figure 2] This is an explanatory diagram showing the removal of background using collinear approximation, performed to find the integrated intensity of each peak of the C1S peaks in Example 1, obtained by means of photoelectric spectroscopy (XPS).
[Figure 3] This is an explanatory diagram showing the comparison of C1S peaks obtained by means of photoelectric spectroscopy (XPS), from Examples 1 and 2, and Comparative Examples 1 and 2.

### DESCRIPTION OF EMBODIMENTS

### (Regarding the processing step of polyimide (PI) film)

The production process of a copper-clad laminated plate includes a processing step of polyimide (PI) film. This step is performed when making holes (through holes) in the PI film or forming flying leads. That is, this step involves removing unnecessary PI film. There are two kinds of method for the PI film processing step (method for removing PI), namely, wet treatment and dry treatment.

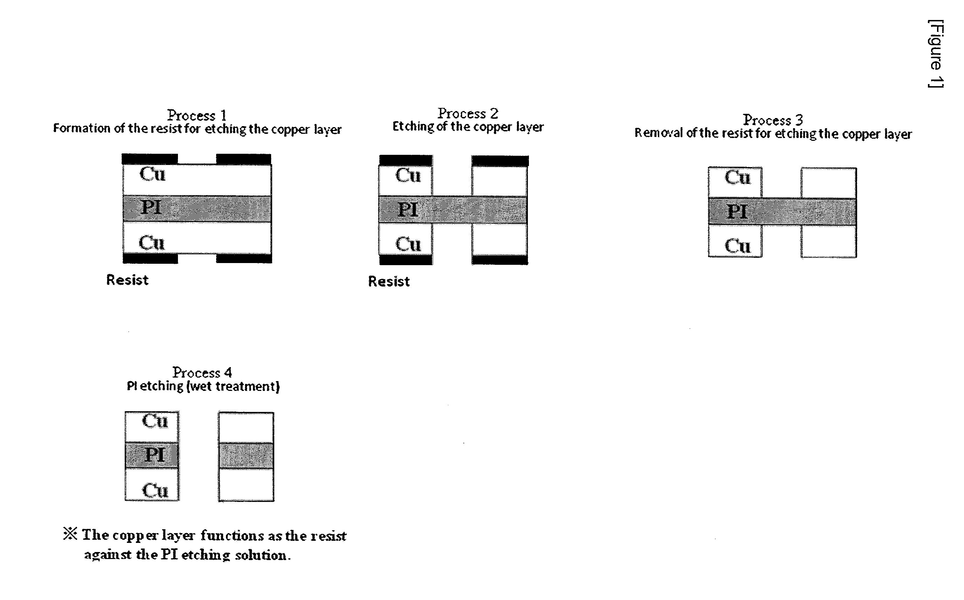

In wet treatment, PI film is dissolved and removed using a PI film etching solution. In the copper-clad laminate plate, the copper layer functions as a resist. The process of dissolving and removing PI film is illustrated in Figure 1.
The wet treatment has low cost and is suited to mass production process. The present invention provides a polyimide (PI) film suitable for the two-layered copper-clad laminated material and a production method for the same.

### (PI film processing step and PI film surface treatment)

The PI film surface treatment step performed during the production of the copper-clad laminate plate is an essential step for improving the adhesiveness between the PI film and the copper layer. When the adhesiveness between the PI and copper layer is not good enough, in addition to the problems during the processing such as circuit loss during etching of the copper layer, long-term reliability after the formation of the circuit deteriorates.

Surface treatment of the PI film results in various changes of PI film proximal to the surface, such as a change in the composition ratio and the state of chemical bond in the surface, depending on surface treatment methods. Therefore it is necessary to study, in detail, the relationships between the changes associated with the surface treatment of PI film and the processing steps of the PI film, and to produce an improved PI film best suited for etching.

In the wet treatment of the PI film, etching is performed by hydrolyzing the PI film by a liquid. Accordingly, depending on the state of chemical bond on the surface, the surface may not be accommodating to hydrolysis, in which case, etching can become difficult. In the present invention, this occurs when a drastic change in the shape of the carbon peak is observed.

The surface of polyimide film placed in a vacuum chamber is activated by plasma treatment. A copper layer of about submicron thickness is then formed by sputtering.
The copper layer thus formed is called a copper seed layer since it will function as the seed for the electrolytic copper layer that is formed in a later step. Prior to forming a copper layer of an about submicron by sputtering, it is also possible to form a tie-coat layer comprising Ni, Cr, Ni-Cu alloy or Ni-Cr alloy by sputtering on the surface of the polyimide film.

As described earlier, depending on the extent of the modification of the polyimide film by plasma treatment, the dissolution properties of the polyimide film can drastically change, causing incomplete etching during the etching step of the polyimide film and a reduction in the yield.
For this reason, the plasma treatment of polyimide film surface was examined in detail. As the result, the following findings were made.

In general, when a polyimide film is subjected to plasma treatment, it results in gaseous adsorption to the surface of polyimide film, desorption, formation of functional groups, and severing of molecular chains. This modified layer greatly affects the dissolution properties of the polyimide film.

It was discovered that, although the modified layer formed by the plasma treatment is essential for achieving the adhesiveness with the metal layer, excessive modification treatment accompanies a change in the molecular structure of the polyimide film surface and alters the dissolution properties of the polyimide film.

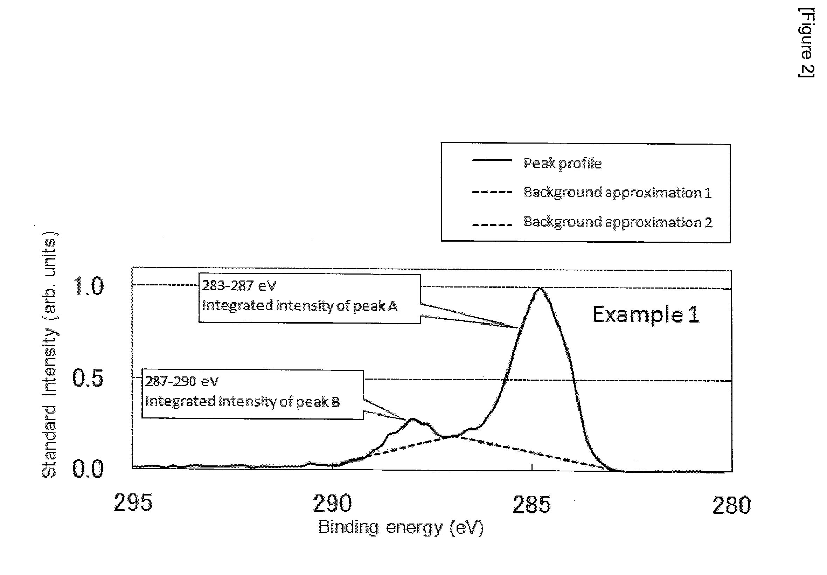

In light of this finding, correlations between the conditions for plasma treatment, the extent of the polyimide film surface modification, adhesive strength, and dissolution properties were examined. The results are shown in Figure 2. Specific details are described in the Examples below. It was found that by controlling the changes in the state of chemical bond of carbon (C) of the polyimide film, it is possible to make adhesive strength compatible with desirable dissolution properties.

The polyimide film of the present invention has a thickness of 12.5 to 50 µm. One surface or both surfaces of the polyimide film are subjected to plasma treatment, and then a copper layer having a thickness of 5 µm or less is formed by means of sputtering or electroplating to produce the two-layered copper-clad laminate material.
By controlling the peak intensity ratio of C1 S peaks of the polyimide film, it became possible to attain the condition where an adhesive property of as-received peel strength is 0.9 kN/m or more, and a dissolution rate of the polyimide film of CCL is not different from that of an untreated polyimide film.

Plasma glow treatment is an electric discharge (glow discharge) phenomenon which occurs when a voltage is applied between an anode and a cathode in the presence of low pressure gas (such as argon, nitrogen and oxygen), in which the rarefied gas is ionized and a plasma comprising electrons and positive gas ions (for example, argon ion, nitrogen ion, and the like) is generated. By exposing the polyimide film to plasma, the positive ions, electrons, and ultraviolet light contained in the plasma act on the surface of the polyimide film, thereby modifying it. Adsorption, desorption, and severing of molecular chains are among the modes of action thought to be occurring during the process.

For the plasma treatment of the present invention, glow discharge of oxygen is preferable and plasma glow treatment in an oxygen gas atmosphere is performed. However, as long as the treatment would modify the polyimide film so that its surface state would have the characteristics described in the Examples below, the surface treatment can be substituted by ion irradiation, ultraviolet irradiation and the like.

Thus, a CCL having as-received peel strength of 0.9 kN/m or more and exhibiting an etching rate against the polyimide film etching solution (TP-3000 manufactured by Toray Engineering) which is similar to that of an untreated polyimide film, is thus obtained. The time for complete dissolution of the polyimide film of the present invention is about 6 to 7 minutes, thereby accomplishing the dissolution of the polyimide film in a very short time.
The polyimide film used for the two-layered CCL material of the present invention, is not especially restricted as long as it can achieve the goal of the present invention. However, preferably, it is effective to use BPDA-PPD based polyimide film.

### [Examples]

The features of the present invention are specifically described below. The explanation is given to facilitate the understanding of the present invention, and not to limit it in any way. In other words, any transformations, embodiments and other examples based on the technical thought of the present invention are thought to be encompassed by the present invention.

### (Example 1)

A copper layer having a thickness of 5 µm was formed by performing plasma treatment, sputtering and plating treatment, using a polyimide film having a thickness of 25 µm (Kapton manufactured by Toray-Dupont).
For the plasma treatment, plasma glow treatment was performed using the glow discharge of oxygen gas under the conditions described below.

Subsequently, 10 nm of a NiCr (20 wt%) tie-coat layer and 200 nm of a copper seed layer were formed by means of sputtering, on which a copper layer having 5 µm thickness was formed by electroplating.
The two-layered CCL thus formed was subjected to electroplating to make the thickness of the copper layer 18 µm, and circuits having a width of 3 mm were formed. Peel strength was then measured at 90°. The reason for having a copper layer at a thickness of 18 µm is to facilitate the measurement of peel strength.

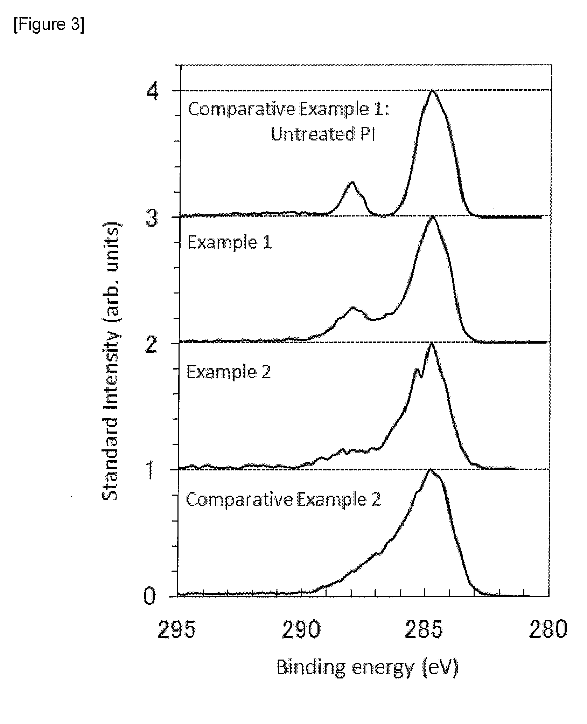

The surface of the polyimide film after the plasma treatment was analyzed by the photoelectron spectroscopy (XPS). Figure 3 shows the comparison of C1S peaks obtained by the photoelectron spectroscopy (XPS). It can be seen from Figure 3 that the peak profile due to C1S changes as the intensity of plasma treatment increases or decreases.
In addition, the integrated intensity ratio of a C1S peak at 287 to 290 eV (peak B) to a C1 S peak at 283 to 287 eV (peak A), was obtained.

The peak at 283 to 287 eV is caused by the state of chemical bonds such as -C-C- and -C-H, while the peak at 287-290 eV is caused by -C=O and the like.
The change in the integrated intensity of the two peaks represents the ratio of the types of chemical bond of C on the PI surface. In other words, the difference from the integrated intensity ratio obtained from a PI that is not subjected to plasma treatment shown in Comparative Example 1, represents the amount of change, by a plasma treatment, in the types of chemical bond of C in a PI. Figure 2 shows how the background was removed by collinear approximation to obtain the integrated intensities of each of the peaks, by using Example 1 as the example.

Further, the metal layer of the two-layered CCL thus produced was completely removed by a mixture of ferric chloride and hydrochloric acid, and it was subjected to washing with water to recover the naked polyimide film. The recovered polyimide film was submerged in TP-3000 at a solution temperature of 50 °C, and the time required for the complete dissolution was measured. The results are shown in Table 1.

**[Table 1]**

| | | Integrated Intensity Ratio of Peak B to Peak A | Time for Complete PI Dissolution | Tie-coat Layer Composition | Tie-coat Layer Thickness (nm) | As-received Peel Strength (kN/m) |
|---|---|---|---|---|---|---|
| Example | 1 | 0.101 | 6 | Ni-Cr(20wt%) | 10 | 0.96 |
| Example | 2 | 0.036 | 7 | Ni-Cr(20wt%) | 10 | 1.00 |
| Example | 3 | 0.097 | 6 | Cr | 7 | 1.00 |
| Example | 4 | 0.034 | 7 | Cr | 7 | 0.93 |
| Comparative Example | 1 | 0.148 | 6 | Ni-Cr(20wt%) | 10 | 0.70 |
| Comparative Example | 2 | 0.000 | 14 | Ni-Cr(20wt%) | 10 | 1.00 |
| Comparative Example | 3 | 0.000 | 14 | Cr | 7 | 1.07 |

As can be seen in Table 1 and Figure 3, excellent results such as an integrated intensity ratio of 0.101, a short polyimide (PI) film dissolution time of 6 min, a composition of the tie-coat layer of Ni-Cr (20wt%), a thickness of the tie-coat layer of 10 nm and as-received peel strength of 0.96 kN/m, were obtained.
The fact that the integrated intensity ratio is lower than 0.148 of Comparative Example 1 suggests that the number of -C=O bonds was reduced by plasma treatment.

### (Example 2)

In Example 2, the identical procedure as in Example 1 was followed except for setting the integrated intensity ratio after the plasma treatment to 0.036. The results are likewise shown in Table 1.
Excellent results such as a short polyimide (PI) film dissolution time of 7 min, a composition of the tie-coat layer of Ni-Cr (20wt%), a thickness of the tie-coat layer of 10 nm and as-received peel strength of 1.00 kN/m, were obtained.
The fact that the integrated intensity ratio is even lower than 0.101 of Example 1 suggests that the number of -C=O bonds was further reduced by plasma treatment. This implies that the change in the state of chemical bond of C on the PI surface is larger than that of Example 1.

### (Example 3)

In Example 3, the identical procedure as in Example 1 was followed except for setting the integrated intensity ratio after plasma treatment to 0.097, changing the composition of the tie-coat layer formed by sputtering to Cr, and setting the thickness of the layer to 7 nm. The results are likewise shown in Table 1.
As a result, excellent results such as a short polyimide (PI) film dissolution time of 6 min, a composition of the tie-coat layer of Cr, a thickness of the tie-coat layer of 7 nm and as-received peel strength of 1.00 kN/m, were obtained.
The fact that the integrated intensity ratio is lower than 0.148 of Comparative Example 1 suggests that the number of -C=O bonds was reduced by plasma treatment.

### (Example 4)

In Example 4, the identical procedure as in Example 1 was followed except for setting the integrated intensity ratio after plasma treatment to 0.034, changing the composition of the tie-coat layer formed by sputtering to Cr, and setting the thickness of the layer to 7 nm. The results are likewise shown in Table 1. As a result, excellent results such as a short polyimide (PI) film dissolution time of 7 min, a composition of the tie-coat layer of Cr, a thickness of the tie-coat layer of 7 nm and as-received peel strength of 0.93 kN/m, were obtained.
The fact that the integrated intensity ratio is even lower than 0.097 of Example 3 suggests that the number of -C=O bonds was further reduced by plasma treatment. This implies that the change in the state of chemical bond of C on the PI surface is larger than that of Example 3.

### (Comparative Example 1)

In Comparative Example 1, the identical procedure as in Example 1 was followed except for not performing the plasma treatment. The results are likewise shown in Table 1. Moreover, the peak intensity of C1S obtained by photoelectron spectroscopy is shown in Figure 3.
As can be seen in Table 1, even though a short polyimide (PI) film dissolution time of 7 min, a composition of the tie-coat layer of Ni-Cr (20 wt%) and thickness of the tie-coat layer of 10 nm were achieved, the as-received peel strength lowered to 0.70kN/m, which is not satisfactory. The integrated intensity ratio is 0.148, reflecting the state of chemical bond of C in the PI film prior to the plasma treatment. Using the integrated intensity ratio of 0.148 of the Comparative Example 1 as the standard, and comparing it to the integrated intensity ratio obtained after the plasma treatment, one can evaluate the extent of the change in the state of chemical bond of C by the plasma treatment.

### (Comparative Example 2)

In Comparative Example 2, the identical procedure as in Example 1 was followed except for performing the plasma treatment at a higher intensity than Examples and setting the integrated intensity ratio after the plasma treatment to 0.0.
The results are likewise shown in Table 1. Moreover, the peak intensity of C1S obtained by photoelectron spectroscopy (XPS) is shown in Figure 3. As can be seen in Table 1, the integrated intensity ratio was 0.0 as described above and the polyimide (PI) film dissolution time was as long as 14 min. The composition of the tie-coat layer was Ni-Cr (20 wt%), the thickness of the tie-coat layer was 10 nm, and the as-received peel strength was as high as 1.00 kN/m, however, as described above, the dissolution time of the polyimide (PI) film was elongated, and as such, was unsatisfactory in terms of its physical property.

The integrated intensity ratio of 0.0 here implies that the -C=O bond virtually does not exist on the PI surface. This suggests that the state of chemical bond of C is completely different from that of the original PI. Accordingly, the chemical reaction by the PI etching solution does not occur readily, resulting in the elongated dissolution time.

### (Comparative Example 3)

In Comparative Example 3, the identical procedure as in Comparative Example 2 was followed except for changing the composition of the tie-coat layer formed by sputtering to Cr, and setting the thickness of the layer to 7 nm. The results are likewise shown in Table 1.
As can be seen in Table 1, the integrated intensity ratio was 0.0 as described above and the polyimide (PI) film dissolution time was as long as 14 min. The composition of the tie-coat layer was Cr, the thickness of the tie-coat layer was 7 nm, and the as-received peel strength was as high as 1.07 kN/m. However, as described above, the dissolution time of the polyimide (PI) film was elongated, and as such, was unsatisfactory in terms of its physical property.

The integrated intensity ratio of 0.0 here implies that the -C=O bond virtually does not exist on the PI surface. This suggests that the state of chemical bond of C is completely different from that of the original PI. Accordingly, the chemical reaction by the PI etching solution does not occur readily, resulting in the elongated dissolution time.

As can be seen in above, in the Examples, the etching time of the polyimide film does not change from that of an untreated polyimide film, even though the as-received peel strength is increased. The integrated intensity ratio is from 0.03 to 0.11 as described.
In contrast, in the Comparative Examples, although the as-received peel strength is increased, a delay in the etching time of the polyimide film is observed.
For improving the adhesiveness between the polyimide and the metal layer, it is necessary to modify the surface by means of plasma treatment and the like. By controlling the extent of the modification, adhesiveness to the metal layer can be achieved without grossly altering the physical properties of the polyimide.

### INDUSTRIAL APPLICABILITY

The two-layered copper-clad laminate material of the present invention exerts an advantageous effect of allowing one to obtain: a two-layered copper-clad laminate material (CCL material) in which a copper layer is formed on a polyimide film by means of sputtering and plating treatment; and especially a two-layered copper-clad laminate material (plate), which has the copper layer of a thickness of no more than 5 µm formed on one surface or both surfaces of the polyimide film having a thickness of 12.5 to 50 µm, and exhibits an excellent adhesiveness of as-received peel strength of 0.9 kN/m or more, and in which the dissolution properties of the polyimide film are not different from that of an untreated PI film.
This allows one to readily dissolve the polyimide film in the etching step of the polyimide film by performing the modification treatment within the extent that would not change the dissolution properties of the polyimide film, without causing the problem of peeling during the copper etching step. Accordingly, the present invention is useful for applications such as medical probes, gas electron multipliers and the like.

## Claims

1. A two-layered copper-clad laminate material, in which one surface or both surfaces of a polyimide film having a thickness of 12.5 to 50 µm is subjected to a modification treatment by means of a glow discharge plasma treatment in an oxygen gas atmosphere, and a copper layer having a thickness of 1 to 5 µm is formed by means of sputtering or electroplating on one surface or both surfaces of the polyimide film after the modification treatment; **characterized in that** the integrated intensity ratio of a C1S peak at 287 to 290 eV to a C1S peak at 283 to 287 eV, obtained by analyzing the surface of the polyimide film after the plasma treatment by means of photoelectron spectroscopy (XPS), is within the range of 0.03 to 0.11.

2. The two-layered copper-clad laminate material according to claim 1, **characterized in that** the polyimide film after the modification treatment does not have a difference in dissolution rate against a polyimide film etching solution compared with an untreated polyimide film.

3. The two-layered copper-clad laminate material according to claims 1 or 2, **characterized in that** the as-received peel strength, when the thickness of the copper layer is 18 µm, is 0.9 kN/m or more.

4. The two-layered copper-clad laminate material according to any one of claims 1 to 3, **characterized in that** a tie-coat layer comprising Ni, Cr, Ni-Cu alloy or Ni-Cr alloy is formed on the polyimide film by means of sputtering, prior to forming a copper layer on one surface or both surfaces of the polyimide film.

5. A production method for a two-layered copper-clad laminate material, in which one surface or both surfaces of a polyimide film having a thickness of 12.5 to 50 µm is subjected to a modification treatment by means of a glow discharge plasma treatment in an oxygen gas atmosphere, and a copper layer having a thickness of 1 to 5 µm is formed by means of sputtering or electroplating on one surface or both surfaces of the polyimide film after the modification treatment; **characterized in that** the integrated intensity ratio of a C1S peak at 287 to 290 eV to a C1S peak at 283 to 287 eV, obtained by analyzing the photoelectron spectroscopy (XPS) spectra of the surface of the polyimide film after the plasma treatment, is within the range of 0.03 to 0.11.

6. The production method for a two-layered copper-clad laminate material according to claim 5, **characterized in that** a tie-coat layer comprising Ni, Cr, Ni-Cu alloy or Ni-Cr alloy is formed on the polyimide film by means of sputtering, prior to forming a copper layer on one surface or both surfaces of the polyimide film.

7. The two-layered copper-clad laminate material according to claims 5 or 6, **characterized in that** the modification treatment is performed so that the polyimide film after the modification treatment does not have a difference in dissolution rate against a polyimide film etching solution compared with an untreated polyimide film.

8. The production method for a two-layered copper-clad laminate material according to any one of claims 5 to 7, **characterized in that** the as-received peel strength, when the thickness of the copper layer is 18 µm, is 0.9 kN/m or more.
